# EUROPEAN PATENT APPLICATION

(11) **EP 4 597 056 A1**
(43) Date of publication of application: **06.08.2025**
(21) Application number: 24154590.4
(22) Date of filing: 30.01.2024
(51) Int. Cl.: G01K 1/143, G01K 7/02, H10N 10/17

(54) **THERMOCOUPLE**

(71) Applicant: Henkel AG & Co. KGaA, 40589 Düsseldorf (DE)
(72) Inventor: Roschek, Tobias, 42699 Solingen (DE); Diepvents, Bart, 3600 Genk (BE)

(57) **Abstract**

The present invention relates to a thermocouple, comprising thermoplastic resin-based silver ink as a first thermocouple element and thermoplastic resin-based carbon ink as a second thermocouple element.

## Description

### Technical field

The present invention relates to a thermocouple formed from a thermoplastic resin-based carbon and silver inks.

### Technical background

Temperature sensing is an important feature in many applications, be it just for information, for temperature control, or for safety measures.

Ordinarily used methods to measure temperature are the resistance temperature detector (RTD), or a thermistor. The RTD has a metallic element possessing a positive temperature coefficient of resistance (decreasing resistance with increasing temperature) and the thermistor has a metal oxide (most common) element exhibiting a negative temperature coefficient (increasing resistance with increasing temperature).

Another way to measure temperature is to use a thermocouple. The ordinary thermocouples are an electrical junction formed by two dissimilar metals, wherein the thermocouples can be formed by joining together a pair of dissimilar metal wires, for example copper and aluminium. The metals are chosen in order to a voltage being observed depending on the size of the temperature difference between the joined and free ends of the pair.

The thermocouple junction produces a voltage, representative of the temperature, and that voltage varies as the thermocouple is exposed to various temperatures. The thermocouple effect is where a temperature differential can be converted directly into electrical voltage, with the amount of electrical energy so generated providing a measurement of the temperature. The observed voltage then provides an estimate of the temperature differential along the length of the pair of wires according to standard equations well known to those of ordinary skill in the art. The metals used to form a thermocouple have been chosen in order to a voltage being observed depending on the size of the temperature difference between the joined and free ends of the pair.

The ordinary thermocouples currently on a market, are generally manufactured from higher cost materials and via higher cost processes and methods. Further, the used thermocouple elements are not fully incorporated in the used surfaces.

Therefore, there is still a need for a thermocouple manufactured via efficient low-cost production and lower cost material, while providing good adhesion and thermal contact to a surface and good temperature measure properties.

### Short description of the figures

Figure 1 illustrates voltage vs. temperature difference for a thermocouple.
Figure 2 illustrates voltage vs. temperature difference for a thermocouple.
Figure 3 illustrates a thermopile comprising four thermocouples according to the present invention.
Figure 4 illustrates voltage of thermopile vs. the temperature difference form cold to hot end.
Figure 5 illustrates results for the thermocouple according to example 1, voltage vs. time for repeated temperature steps (RT - 70°C - 120°C - 70°C - RT).
Figure 6 illustrates results for the RTD, voltage vs. time for repeated temperature steps (RT - 70°C - 120°C - 70°C - RT).

### Summary of the invention

The present invention relates to a thermocouple, comprising a) a substrate; b) a first thermocouple element printed on the substrate, wherein the first thermocouple element is a silver ink; and c) a second thermocouple element printed on the substrate, wherein the second thermocouple element is a carbon ink, wherein at least a portion of the second thermocouple element is in electrical contact with the first thermocouple element, and wherein the first and second printed thermocouple elements together produce a thermoelectric effect.

The present invention also relates to a thermopile, comprising two or more thermocouples according to the present invention arrayed in close proximity with each other.

The present invention encompasses use of the thermocouple according or the thermopile according to the present invention as a temperature sensor.

### Detailed description of the invention

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous.

In the context of the present invention, the terms used are to be construed in accordance with the following definitions, unless a context dictates otherwise.

As used herein, the singular forms "a", "an" and "the" include both singular and plural referents unless the context clearly dictates otherwise.

The terms "comprising", "comprises" and "comprised of" as used herein are synonymous with "including", "includes" or "containing", "contains", and are inclusive or open-ended and do not exclude additional, non-recited members, elements or method steps.

As used herein, the term "*consisting of*" excludes any element, ingredient, member or method step not specified.

The words *"preferred", "preferably", "desirably"* and *"particularly"* are used frequently herein to refer to embodiments of the disclosure that may afford particular benefits, under certain circumstances. However, the recitation of one or more preferable, preferred, desirable or particular embodiments does not imply that other embodiments are not useful and is not intended to exclude those other embodiments from the scope of the disclosure.

As used throughout this application, the word *"may"* is used in a permissive sense - that is meaning to have the potential to - rather than in the mandatory sense.

The recitation of numerical end points includes all numbers and fractions subsumed within the respective ranges, as well as the recited end points.

All percentages, parts, proportions and then like mentioned herein are based on weight unless otherwise indicated.

When an amount, a concentration or other values or parameters is/are expressed in form of a range, a preferable range, or a preferable upper limit value and a preferable lower limit value, it should be understood as that any ranges obtained by combining any upper limit or preferable value with any lower limit or preferable value are specifically disclosed, without considering whether the obtained ranges are clearly mentioned in the context.

All references cited in the present specification are hereby incorporated by reference in their entirety.

Unless otherwise defined, all terms used in disclosing the invention, including technical and scientific terms, have the meaning as commonly understood by one of the ordinary skilled in the art to which this invention belongs to. By means of further guidance, term definitions are included to better appreciate the teaching of the present invention.

The present invention relates to a thermocouple, comprising a) a substrate; b) a first thermocouple element printed on the substrate, wherein the first thermocouple element is a silver ink; and c) a second thermocouple element printed on the substrate, wherein the second thermocouple element is a carbon ink, wherein at least a portion of the second thermocouple element is in electrical contact with the first thermocouple element, and wherein the first and second printed thermocouple elements together produce a thermoelectric effect.

Both thermocouple elements can be printed onto a surface of the substrate and therefore enable efficient low-cost production. In addition, the printed thermocouple elements provide a direct adhesion and good thermal connection to a measured surface. Further, the surface of the thermocouple according to the present invention stays essentially as a surface, there is no need to incorporate a cable for example.

The first and second thermocouple elements according to the present invention are based thermoplastic resins, which are recyclable and provide good adhesion properties while providing resistivity to chemicals.

The thermocouple according to the present invention comprises a substrate.

Suitable substrate for use in the present invention may be a flexible or a non-flexible non-conductive substrate. Alternatively, the substrate may be a conductive metal substrate having an insulation coating covering the surface of the metal substrate, wherein the thermocouple is applied onto.

When the substrate is a flexible or a non-flexible non-conductive substrate it may be selected from the group consisting of polyethylene terephthalate (PET), treated polyethylene terephthalate, polycarbonate, polyimide, paper, polyurethane, rubber, textiles, polyester, polyolefin and mixtures thereof.

When the substrate is a conductive metal substrate, it has an insulation coating layer covering the surface.

There are no limitations on what metal can be used as a conductive metal substrate in the present invention, mercury of course being an obvious exception.

Suitable insulation coating for use in the present invention may be selected from the group consisting of an epoxy resin, a (meth)acrylate resin, a silicone resin, a polyester resin, a polyurethane resin, a polyvinyl chloride, and mixtures thereof, preferably the insulation coating is a (meth)acrylate resin.

The insulation coating may cover complete surface of the metal substrate. However, for the thermocouple to be functional, the insulation coating should cover at least 100% of the interface between the silver ink and carbon ink and surface of the metal.

Thickness of the insulation coating layer is preferably about 50µm. This thickness is sufficient to provide required insulation, and to ensure that the insulation coating layer does not have pinholes in the coating.

The first thermocouple element is a silver ink, preferably comprising silver particles, a thermoplastic resin, and a solvent.

The silver ink comprises silver particles which provide the electrical conductivity to the silver ink.

The silver particles may have acicular, spherical, ellipsoidal, cylindrical, bead-like, cubic, or platelet-like shape. Any particle may be used alone or in combination. The silver particles may be for example a mixture of spherical particles and flake particles.

The silver particles will conventionally have an average volume particle size, as measured by laser diffraction / scattering methods, of from 300 nm to 50 µm, preferably from 500 nm to 40 µm, more preferably from 500 nm to 30 µm.

In a highly preferred embodiment, the electrically conductive particles have D10 about 1 µm, D50 about 5 µm and D90m about 12 µm.

In the aforementioned measurement method, the particle size is measured by particle size analyser and the particle shape is analysed by scanning electron microscope. In short, scattered laser lights from the particles are detected an array of detectors. Theoretical calculation is carried out to fit the measured distribution of scattered light intensity. During the fitting process the particle size distribution is deduced and inter alia D10, D50 and D90 values are calculated accordingly.

Particle size is measured by using particle size distribution (PSD) method. The average particle size is measured in the present invention through laser diffractometry preferably using a Malvern Mastersizer 2000 or Malvern Mastersizer 3000 available from Malvern Instruments Ltd. or Horiba LA-950V2 from Horiba Ltd.. In this technique, the size of particles in suspensions or emulsions is measured using the diffraction of a laser beam, based on application of either Fraunhofer or Mie theory. In the present invention, Mie theory or a modified Mie theory for non-spherical particles is applied and the particle sizes relate to scattering measurements at an angle from 0.02 to 135 degrees relative to the incident laser beam.

For clarity, it is noted that suitable silver particles for use in the present invention may be a mixture of particles having a small particle size and particles having a larger particle size.

In an independent characterization of the particles, which may or may not compliment the aforementioned particle size distribution, it is preferred that the silver particles have a tap density from 0.5 to 6.0 g/cm³, preferably from 0.5 to 5.5 g/cm³ and more preferably from 0.5 to 5.0 g/cm³ as determined in accordance to ISO 3953 using a 25 cm³ graduated glass cylinder. The principle of the method specified is tapping a specified amount of powder in a container by means of a tapping apparatus until no further decrease in the volume of the powder takes place. The mass of the powder divided by its volume after the test gives its tap density.

In an independent characterization of the silver particles, which may or may not compliment the aforementioned particle size distribution, it is preferred that the silver particles have specific surface area from 0.3 to 2 m²/g, preferably from 0.5 to 1.5 m²/g and more preferably from 0.75 to 1.3 m²/g. The term "specific surface area" as used herein refers to the BET specific surface area which is determined in accordance with ASTM B922-10 widely using nitrogen as an analysis gas.

Suitable commercially available silver particles for use in the present invention include but are not limited to AA-3452W from Metalor.

The silver particles may be present in the silver ink in an amount from 20 to 90 wt.% by weight based on the total weight of the composition, preferably from 30 to 85 wt.%, more preferably from 45 to 80 wt.% and even more preferably from 50% to 75%.

Above defined quantities are preferred because they provide ideal conductivity for the silver ink. If the silver quantity is less than 20% this may lead to a poor coverage and poor conductivity, whereas higher quantity than 90% quantity may lead to poor adhesion properties and too viscose ink causing difficulties in printing process.

The resin adheres the silver ink to the substrate and keep the silver ink composition together.

Suitable resin for use in the silver ink may be selected from the group consisting of thermoplastic polyurethanes, thermoplastic polyvinyl chloride, polyesters, polyacrylates, polysiloxanes, halogenated vinyl or vinylidene polymers, polyamide copolymers, phenoxy resins, polyethers, polyketones, polyvinyl butyral, polyvinyl pyrrolidone, polycyanoacrylates and mixtures thereof, preferably the resin is selected from the group consisting of thermoplastic polyurethanes, thermoplastic polyvinyl chloride and mixtures thereof.

Thermoplastic polyurethanes are preferred because they are flexible, and therefore, ideally suitable for flexible substrates as they do not tend to crack upon bending or stretching. Thermoplastic polyurethanes are also compatible with PET substrates.

In a highly preferred embodiment, the resin used in the silver ink is a combination of thermoplastic polyurethane and thermoplastic polyvinyl chloride.

Suitable commercially available resins for use in the present invention include but are not limited to ESTANE 5715 and ESTANE 5703 from Lubrizol Company and SARAN F-310 from DOW.

The resin may be present in the silver ink in a quantity from 0.1 to 15 wt.% by weight of the total weight of the composition, preferably from 2 to 10 wt.% and more preferably from 4 to 9 wt.%.

The above defined quantities are preferred, because too low quantity of the resin, less than 0.1%, may lead to poor adhesion of the silver ink to a substrate, whereas too high quantity, more than 15% may lead to decreased electrical conductivity.

The silver ink comprises a solvent. The solvent acts as a carrier and aids the application of the silver ink composition onto a substrate. The solvent is evaporated during the drying procedure resulting an electrically conductive printed layer.

Suitable solvent may be selected based on the printing method to be used to apply the silver ink onto a surface. For example, solvents with higher boiling point are generally used in screen printing to prevent drying of the ink on the screen. And solvents with lower boiling point are generally used in high-speed printing, e.g. flexographic and rotogravure printing because the drying speed of the ink is limiting the printing speed.

Suitable solvent for use in the silver ink may be selected from the group consisting of 2-butoxyethyl acetate, 2-(2-butoxyethoxy)ethanol, [2-(2-butoxyethoxy)-ethyl]acetate, 2-butoxyethanol, isophorone, 3,3,5-trimethyl-2-cyclohexene-1-one, dimethyl succinate, dimethyl glutarate, dimethyl adipate, acetic acid, 1-methoxypropan-2-ol, 1-methoxy-2-propylacetate, dipropylene glycol (mono)methyl ether, toluene, ethanol, isopropyl alcohol, n-propanol, ethoxy propanol, ethyl acetate, butyl acetate, n-propyl acetate, isopropyl acetate, methyl ethyl ketone, methyl isobutyl ketone, water, glycol ethers, dibasic esters, ethanol, isopropyl alcohol, n-propanol, ethoxy propanol, ethyl acetate, butyl acetate, n-propyl acetate, isopropyl acetate, butyl glycol acetate, carbitol acetate, 1-methoxypropan-2-ol, 1-methoxy-2-propylacetat, methyl ethyl ketone, methyl isobutyl ketone, water and mixtures thereof.

Above mentioned solvents are preferred because they dissolve the resin well and are easily released during the drying process.

Suitable commercially available solvents for use in the present invention include but are not limited to carbitol acetate and DBE-9 from Sigma-Aldrich.

The solvent may be present in the silver ink composition in a quantity from 5 to 80 wt.% by weight of the total weight of the composition, preferably from 10 to 60 wt.% and more preferably from 20 to 50 wt.%.

These solvent quantities are preferred because if the solvent quantity is below 5% the viscosity of the silver ink may be too high and the ink may not be suitable for printing, whereas, if the solvent quantity is more than 80% the viscosity may be too low, and the dried ink layer may be too thin.

The silver ink may further comprise additives that can impart improved properties to this composition. For instance, the additives may impart one or more of: improved elastic properties; improved elastic recovery; improved adhesion; longer enabled processing time; faster curing time; film forming properties, and lower residual tack.

The silver ink may further comprise one or more optional component selected from the group consisting of surface-active agents, surfactants, wetting agents, antioxidants, thixotropes, reinforcement fibres, waxes, adhesion promoters, rheology modifiers, spacer beads, additives that lowers the resistance of the composition, such as p-TSA, and mixtures thereof. The additional ingredients are optional and are specifically chosen to obtain any desired properties for the chosen end use.

When used, these optional components may be present in the silver ink from 0.01 to 10 wt.% by weight based on the total weight of the composition, preferably from 0.01 to 5 wt.%.

The silver ink ideally has a viscosity from 2000 to 80000 mPas, wherein the viscosity is measured according to ISO 3219 using a rheometer at a constant shear rate of 1.5-s with a 20 mm plate-plate configuration (0.2 mm gap, 60 sec, at 25 °C).

The second thermocouple element is a carbon ink, preferably comprising a mixture of carbon-based particles selected from the group consisting of carbon black, graphite, carbon nanotubes, carbon nanoparticles and mixtures thereof; a thermoplastic resin; and a solvent.

The carbon ink preferably comprises a mixture of carbon-based particles. Suitable particles may be selected from the group consisting of carbon black, graphite, carbon nanotubes, carbon nanoparticles and mixtures thereof.

In a highly preferred embodiment, the carbon ink comprises a mixture of graphite and carbon black, wherein ratio of the graphite and the carbon black is from 1:1 to 5:1.

Suitable graphite for use in the carbon ink has preferably a particle size D90 from 1 µm to 75 µm, more preferably from 2 µm to 45 µm, more preferably from 3 µm to 25 µm and even more preferably 3 µm to 10 µm. Wherein the particle size is measured by laser diffraction. In this method a laser beam lights up a cell which contains the sample of graphite suspended in water, the generated diffraction pattern is collected by the system and analysed using the light scattering developed by Mie. The particle size distribution is calculated and reported for quantity of 90%.

In addition to particle size D90, or as an alternative feature of suitable graphite for use in the present invention is a specific surface area preferably from 0.25 m²/g to 25 m²/g, more preferably from 4 m²/g to 22 m²/g and more preferably from 7 m²/g to 21 m²/g, wherein the specific surface area is measured by B.E.T nitrogen absorption. The measurement is carried out by measuring the adsorption-desorption isotherm of nitrogen on the surface of the material by means of the Brunauer-Emmet-Teller algorithm, a definite amount (accuracy 0.01mg) of powder is weighted in a sample tube. Subsequently the sample undergoes a series of heating and cooling runs from the evolution of the pressure in the sample tube and the amount of adsorbed nitrogen during different step is calculated; from this data the specific surface area is calculated and reported in m²/g.

In a preferred embodiment the graphite has a particle size D90 from 1 µm to 75 µm, preferably from 2 µm to 45 µm, more preferably from 3 µm to 25 µm and even more preferably 3 µm to 10 µm and/or a specific surface area from 0.25 m²/g to 25 m²/g, preferably from 4 m²/g to 22 m²/g and more preferably from 7 m²/g to 21 m²/g, wherein the particle size is measured by laser diffraction, and wherein the specific surface area is measured by B.E.T nitrogen absorption.

Preferred specific surface areas and particle sizes of a graphite as separate features or as a combination provide low resistance and good conductivity in thin layers as well as good printability.

Generally, too large particle size of a graphite may lead to a lower specific surface area, and in addition, difficulties to release the particles from the cells during the printing process. Whereas too small particle size of a graphite may be too expensive to produce, and have larger specific surface area, which may lead to a higher viscosity. High viscosity is not ideal for a high-speed printing and creates a need for a heavy dilution prior to application, which may adversely affect conductivity of the printed layer.

Lower graphite specific surface area than 0.25 m²/g may lead to decrease of conductivity, whereas higher specific surface area than 25 m²/g may lead problems with viscosity of the composition and additionally, would not be cost effective component.

Suitable commercially available graphite for use in the present invention include but is not limited to Timrex SFG6 from TIMCAL Graphite & Carbon.

Suitable carbon black for use in the carbon ink has preferably an oil absorption number from 70 ml/100g to 500 ml/100g, more preferably from 100 ml/100g to 300 ml/100g and more preferably from 150 ml/100g to 200 ml/100g, wherein the oil absorption number is measured according to ASTM D2414.

In addition to oil absorption number, or as an alternative feature suitable carbon black for use in the present invention has a specific surface area preferably from 30 m²/g to 1400 m²/g, more preferably from 100 m²/g to 700 m²/g and more preferably from 150 m²/g to 350 m²/g, wherein the specific surface area is measured according by BET. The method is based on the registration of the absorption of nitrogen at 77K. Following the model proposed by Brunauer, Emmet and Teller (BET), the monolayer capacity can be determined. On the basis of the cross-sectional area of the nitrogen molecule, the monolayer capacity and the weight of the sample, the specific surface can then be calculated.

In a preferred embodiment the carbon black has an oil absorption number from 70 ml/100g to 500 ml/100g, preferably from 100 ml/100g to 300 ml/100g and more preferably from 150 ml/100g to 200 ml/100g, and/or a specific surface area from 30 m²/g to 1400 m²/g, preferably from 100 m²/g to 700 m²/g and more preferably from 150 m²/g to 350 m²/g, wherein the oil absorption number is measured according to ASTM D2414, and wherein the specific surface area is measured according by BET.

Preferred specific surface areas and oil absorption numbers separate or as a combination provide a good printability properties and low resistance in thin layers.

When the oil absorption number of the carbon black is too low, it means less branched carbon black, and therefore, there may be fewer contact points in thin layers, and this will adversely affect conductivity, whereas too high oil absorption number of the carbon black, mainly greater than 500, may cause difficulties in printing process.

When the specific surface area size of the carbon black is too small, mainly less than 30, this may lead to a poor conductivity, whereas too high specific surface area of the carbon black, mainly more than 1400, may lead difficulties in printing process.

Suitable commercially available carbon black for use in the present invention include but is not limited to Vulcan XC72 from Cabot and Ensaco 250G from Imerys.

The ratio of the graphite and the carbon black in the carbon ink is from 1:1 to 5:1, preferably from 2:1 to 4:1, and more preferably ratio of the graphite and the carbon black is 3:1.

The Applicant has found out that these graphite to carbon black ratios provide ideal viscosity and conductivity properties to the composition according to the present invention. It has been found that too high carbon black concentration in relation to graphite may lead thicker printed layers. Further, if the quantity of the carbon black is too high, viscosity of the composition may increase too high, and the composition may no longer be high-speed printable.

Suitable carbon nanostructures and carbon nanotubes for use in the carbon ink may have the particle size preferably from 1 nm to 25 nm, preferably from 2 nm to 20 nm and more preferably from 3 nm to 15 nm, wherein the particle size is measured by laser diffractometry.

Suitable commercially available carbon nanotubes for use in the present invention include but is not limited to GPX801 from Gabot.

The carbon-based particles may be present in the carbon ink in an amount from 3 to 45% by weight of the total weight of the composition, preferably from 4 to 43%, and more preferably from 4.75 to 41%.

When the quantity of the carbon-based particles is too low, mainly less than 3%, the quantity may not provide desired conductivity, whereas too high quantity, mainly more than 45%, may lead difficulties to process the composition in a printing process.

The carbon ink comprises a thermoplastic resin. Suitable thermoplastic resin for use in the present invention is selected from nitrocellulose, chlorinated polyester, chlorinated polyether, chlorinated polyvinyl, chlorinated polyacetate and mixtures thereof, preferably the thermoplastic resin is nitrocellulose.

By the term chlorinated polyvinyl is meant herein vinyl chloride polymer (homopolymer) and/or vinyl chloride copolymers comprising 2, 3, 4 or more co-monomers.

By the term chlorinated polyester is meant herein a copolymers of vinyl chloride and copolymerizable polyester oligomers.

By the term chlorinated polyether is meant herein copolymers of vinyl chloride and copolymerizable polyether oligomers.

By the term chlorinated polyacetate is meant herein a copolymer of vinylchloride and vinyl acetate.

Preferably chlorinated polyvinyl is selected from the group consisting of vinyl chloride polymer, vinyl chloride vinyl acetate copolymer, vinyl chloride vinyl stearate copolymer, vinyl chloride 1,2-dichloroethene copolymer, vinyl chloride (meth)acrylonitrile copolymer, vinyl chloride methyl(meth)acrylate copolymer, vinyl chloride butyl(meth)acrylate copolymer, vinyl chloride dicarboxylic acid copolymer, vinyl chloride fumaric acid copolymer, vinyl chloride maleic acid copolymer, vinyl chloride dibutyl fumarate copolymer, vinyl chloride diethyl maleate copolymer, terpolymer of vinyl chloride, vinyl acetate and dicarboxylic acid, terpolymer of vinyl chloride - vinyl acetate - vinyl alcohol and mixtures thereof.

Preferably chlorinated polyester is selected from copolymers of vinyl chloride and polyester acrylate oligomers.

Preferably chlorinated polyether is selected from copolymers of vinyl chloride and polyether acrylate oligomers, such as dipropylene glycol diacrylate.

Preferably chlorinated polyacetate is a copolymer of vinylchloride and vinyl acetate.

The selected resins release the solvent easily, which makes the composition suitable for consumer usage. Further, these resins are preferred because they provide low resistance and high conductivity. Generally, these resins disperse well the carbon-based particles.

In one highly preferred embodiment, nitrocellulose is used as a thermoplastic resin. Nitrocellulose is particularly preferred because it provides superior conductivity, while it dissolves well and releases the used solvent quickly.

In another highly preferred embodiment vinyl chloride - vinyl acetate - vinyl alcohol terpolymer is used as a resin.

Suitable commercially available resins for use in the present invention include but are not limited to Solbin A from ShinEtsu and NC-E560 IPA 30% from Dow.

A resin may be present in the carbon ink in an amount from 2 to 25% by weight of the total weight of the composition, preferably from 3 to 23%, and more preferably from 4 to 21%.

When the quantity of the thermoplastic resin exceeds 25% the viscosity of the carbon ink may increase to the level that the composition is no longer high-speed printable, whereas too low quantity, less than 2% may lead to a poor coating, low viscosity and settling of the resin and electrically conductive particles.

The Applicant has found out that particularly good properties are obtained, and the composition can be used in a high-speed printing when the ratio of the carbon-based particles and the resin is from 0.20:1 to 4:1, preferably from 0.25:1 to 3:1.

The Applicant has found that this ratio of carbon-based particles and resin provides good viscosity and good conductivity properties.

The carbon ink comprises a solvent. The solvent acts as a carrier and aids the application of the ink composition onto a substrate. The solvent is evaporated during the drying procedure resulting an electrically conductive printed layer.

The carbon ink may comprise one solvent or mixture or two or more solvents. It is preferred that the solvent has relatively low boiling point, preferably below 119°C, more preferably boiling point is from 80°C to 105°C. Solvents with relatively low boiling point are preferred because they dry fast and enable fast-printing speed.

In a preferred embodiment the solvent for the carbon ink is selected from the group consisting of toluene, ethanol, isopropyl alcohol, n-propanol, ethyl acetate, n-propyl acetate, isopropyl acetate, methyl ethyl ketone, methyl isobutyl ketone, water and mixtures thereof, preferably solvent is selected from ethyl acetate, isopropyl alcohol, n-propyl acetate and mixtures thereof, more preferably selected from isopropyl alcohol, n-propyl acetate and mixtures thereof.

These solvents are preferred because they dissolve the resin well and are easily released during the drying process.

Suitable commercially available solvent for use in the present invention include but is not limited to ethyl acetate from Eastman and butyl acetate from Eastman.

A solvent may be present in the carbon ink in an amount from 40 to 92% by weight of the total weight of the composition, preferably from 45 to 91%, and more preferably from 46 to 90%.

If the solvent quantity is lower than 40%, the viscosity of the composition may increase too high, and therefore, adversely affect the printing properties of the composition, whereas higher quantity, more than 92% may adversely affect the conductivity of the composition.

The carbon ink may further comprise additives that can impart improved properties to this composition. For instance, the additives may impart one or more of: improved elastic properties; improved elastic recovery; improved adhesion; longer enabled processing time; faster curing time; film forming properties, and lower residual tack.

The carbon ink may further comprise one or more optional component selected from the group consisting of surface-active agents, surfactants, wetting agents, antioxidants, thixotropes, reinforcement fibres, waxes, adhesion promoters, rheology modifiers, spacer beads and mixtures thereof. The additional ingredients are optional and are specifically chosen to obtain any desired properties for the chosen end use.

When used, these optional components may be present in the carbon ink from 0.01 to 10 wt.% by weight based on the total weight of the composition, preferably from 0.01 to 5 wt.%.

The carbon ink has preferably viscosity from 600 to 5000 mPas, preferably from 650 to 3000, and more preferably from 700 to 2000 mPas, wherein viscosity is measured Brookfield (DV-I prime), spindle #2 at 20, at room temperature.

The Applicant has found that this viscosity range is ideal for the production process used to produce the carbon ink and in addition, this viscosity range prevents composition settling during the storage.

The first and second thermocouple elements may be printed onto a substrate using screen printing, rotogravure printing, or flexographic printing. Screen printing is preferred printing method.

There is no particular order in which the first and second thermocouple elements are printed onto a substrate.

In one embodiment, the first thermocouple element is printed first onto a substrate and the second thermocouple element is printed second onto a substrate.

In another embodiment, the second thermocouple element is printed first onto a substrate and the first thermocouple element is printed second onto a substrate.

In a preferred embodiment, the first thermocouple element is printed first onto a substrate and the second thermocouple element is printed second onto a substrate.

The first thermocouple element and the second thermocouple element are printed in a way that at least a portion of the second thermocouple element is in electrical contact with the first thermocouple element, wherein the first and second printed thermocouple elements together produce a thermoelectric effect. The thermoelectric effect is the direct conversion of temperature differences to electric voltage and vice versa via a thermocouple.

In one embodiment, the first and second thermocouple elements may be printed top of each other.

In another, preferred embodiment, the first and second thermocouple elements may be printed parallel to each other, having one part of the elements either touching or crossing each other.

The thickness of the printed first and second thermocouple elements may be same or different. The preferred thickness may be of from 0.1 to 200µm, preferably from 0.5 to 100µm, and more preferably from 1 to 50µm.

These are preferred thicknesses, because too thin layer, less than 0.1µm may not provide adequate conductivity, whereas too thick layer, more than 200µm, may be hard to print and would not provide any technical benefit, but increase the costs.

In a preferred embodiment, the thickness of the first thermocouple element is from 5 to 8µm and the thickness of the second thermocouple element is from 10 to 15µm.

There thicknesses are preferred because they are providing good and constant resistance and sheet resistance. Generally, the silver ink is made to print very thin lines, because the silver ink can maintain the same sheet resistance at lower thicknesses, whereas the carbon ink needs slightly higher thickness to avoid increase in resistance and sheet resistance.

The width of the printed first and second thermocouple elements may be same or different. The preferred width may be of from 0.15 to 10mm, preferably from 0.2 to 5mm, and more preferably from 0.5 to 2.5mm.

This width range provides good and uniform conductive path. Too narrow width (less than 0.15mm) may not be uniform enough and conductivity may not be ideal, whereas too wide width may not provide any technical benefit, but takes more space on a substrate and increases the costs.

The thermocouple according to the present invention may further comprise electrical connectors electrically coupled to the first and second thermocouple elements.

The thermocouple according to the present invention may further comprise an overcoat layer covering partially or full the first and second printed thermocouple elements.

The overcoat layer may be the same or different than the insulation coating and may be independently selected from the group consisting of an epoxy resin, a (meth)acrylate resin, a silicone resin, a polyester resin, a polyurethane resin, a polyvinyl chloride and mixtures thereof, preferably the overcoat layer is a (meth)acrylate resin.

The present invention also relates to a thermopile. The thermopile is a series connection of multiple thermocouples with the junctions alternating between the hot and cold ends. That way the signal can be increased by a factor corresponding to the number of series connected thermocouples.

The thermopile according to the present invention comprises two or more thermocouples according to the present invention arrayed in close proximity with each other.

The present invention also relates to use of the thermocouple or the thermopile according to the present invention as a temperature sensor.

The thermocouple according to the present invention can be used to measure local change of skin temperature or relative change to a room temperature, or when spatial resolutions need to be measured or when a large temperature range needs to be covered.

### Examples

Following silver and carbon inks were used in the examples:
LOCTITE ECI1010 BULK available from Henkel AG & Co. KGaA
LOCTITE 7007 E&C available from Henkel AG & Co. KGaA
LOCTITE Electrodag PF407A available from Henkel AG & Co. KGaA

### The printing process:

The thermocouples and thermopiles were printed on PET substrates (Autostat CUS 5) using a screen-printing process and hardened using thermal annealing. The parameters are listed in table 1 below.

**Table 1**

| | Parameter | Standard |
|---|---|---|
| Screen / stencil printer | Screen | BSC001a (LOCTITE ECI1010) |
| Thieme lab 1000 | | |
| Ird. 6.4-119 | | BSC001b (LOCTITE 7007 E&C and LOCTITE Electrodag PF407A) |
| | Substrate | Autostat CUS 5 |
| | Squeegee hardheld (Shore A) | 85 ShA |
| | Off contact (mm) | 1.6 |
| | Squeegee press. (bar) | 3.5 |
| | Print speed (mm/s) | 200 |
| | Flood speed (mm/s) | 200 |
| | EOM (µ*m*) | 13-17 |
| | Mesh | 63-36 |
| | Emulsion type | MS&MS |
| | | |
| Convection box oven | Cure | 15 min at 120°C for LOCTITE 7007 E&C (printed first) |
| Heraeus Ird. 6.4-102 | | |
| | | 15 min at 120°C for LOCTITE ECI1010 (printed second) |

### Example 1

A thermocouple was produced by printing LOCTITE ECI1010 as the first thermocouple element and LOCTITE 7007 E&C as a second thermocouple element to form the thermocouple. For ease of manufacturing and for a well-defined overlap the printed lines were meeting at a right angle (90°).

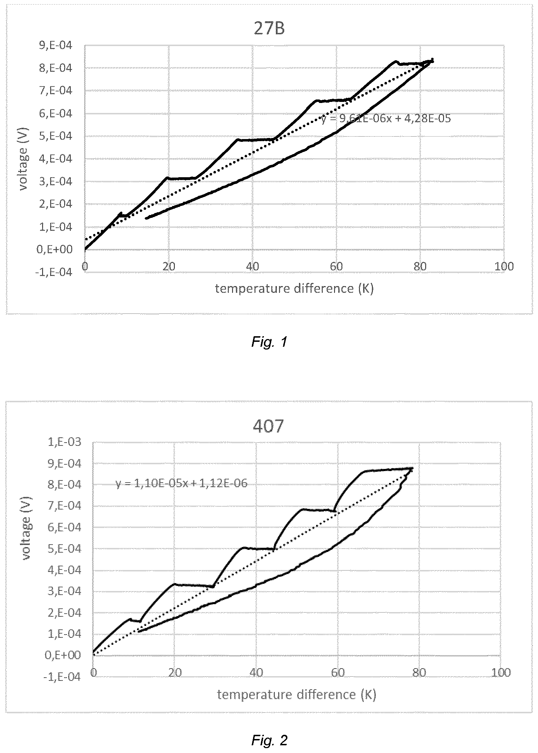

Figure 1 illustrates voltage vs. temperature difference for the thermocouple according to example 1. The thermocouple according to example 1 showed Seebeck coefficient of 9.6µV/K. The (relative) Seebeck coefficient is defined as the increase of the voltage difference divided by the applied temperature difference across a thermocouple.

In this context, and in the other examples below, it is noted that the examples are referring to a relative Seebeck coefficient, wherein two materials are comparing two materials.

### Example 2

A thermocouple was produced by printing LOCTITE ECI1010 as the first thermocouple element and LOCTITE Electrodag PF407A as a second thermocouple element to form the thermocouple. For ease of manufacturing and for a well-defined overlap the printed lines were meeting at a right angle.

Figure 2 illustrates voltage vs. temperature difference for the thermocouple according to example 2. The thermocouple according to example 2 showed Seebeck coefficient of 11µV/K.

### Example 3

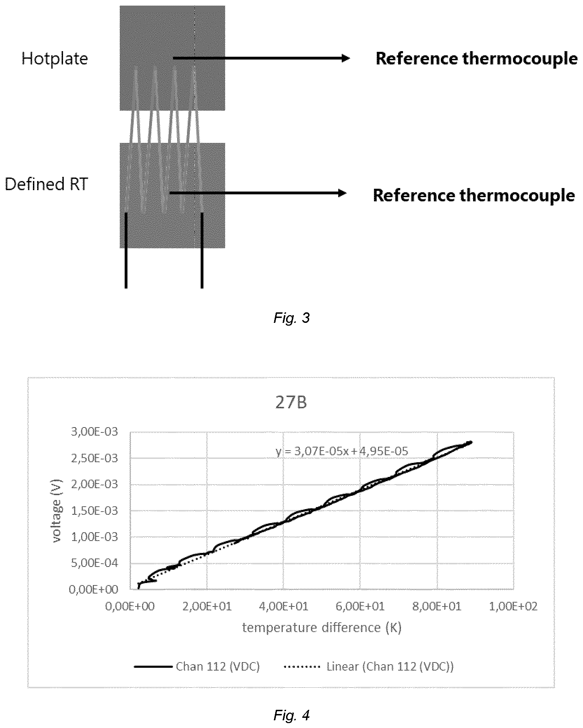

A thermopile (illustrated in figure 3) was produced by printing LOCTITE ECI1010 as the first thermocouple element and LOCTITE 7007 E&C as a second thermocouple element to form four thermocouples.

The voltage was generated by the thermopile and the temperature difference was recorded at both ends using a datalogger Keithley DAQ970A. The hot side of the thermopile was placed on a hotplate (Biostep Thermoplate Splus) while the cold side was left at room temperature.

A thermopile was measured by increasing the temperature stepwise from room temperature to 120°C. The loop shape of the curve during heat up was caused by a different stabilization time of the printed thermocouples and the reference thermocouples of the datalogger. The end points of the loops are where all thermocouples were stabilized and where the gradient could be taken. It is noted that during the cooling of the hotplate there were no steps for stabilization. The gradient of the thermopile was 31 µV/K (corresponding to about 8µV/K per involved thermocouple). The results are illustrated in figure 4.

### Example 4

This is example is a comparative example exemplifying resistive temperature detector (RTD) of same materials. The RTD consisted of a detecting carbon track connected by silver leads (that way the carbon dominated the overall resistance).

For a comparison of repeatability and hysteresis the thermocouple of example 1 and the RTD were subjected to heat cycles (RT - 70°C - 120°C - 70°C - RT). The change of the overall resistance is measured and correlated to the temperature.

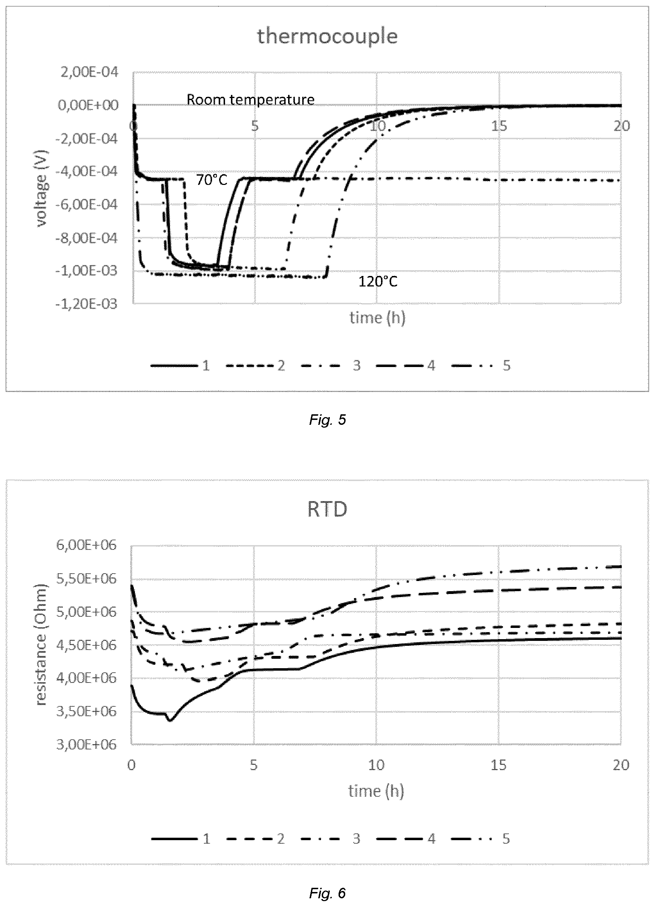

Figure 5 illustrates results for the thermocouple according to example 1, voltage vs. time for repeated temperature steps (RT - 70°C - 120°C - 70°C - RT).

Figure 6 illustrates results for the RTD, voltage vs. time for repeated temperature steps for the RTD (RT - 70°C - 120°C - 70°C - RT).

Looking at the results of temperature cycling for a thermocouple the plateaus at the different temperatures are quite distinguished and reproducible. Slight deviation in values can be attributed to a change in room temperature. Looking in comparison at the results of an RTD it is clear that the resistance drifts strongly when subjected to a temperature of 120°C. The same resistance change is expected within a thermocouple, but without affecting the output voltage.

The examples including the comparative example exemplify that it is difficult to get a functioning RTD using commercially available electrically conductive inks. However, a good solution is to produce thermocouple with electrically conductive inks as illustrated in the examples.

## Claims

1. A thermocouple, comprising
a) a substrate;
b) a first thermocouple element printed on the substrate, wherein the first thermocouple element is a silver ink; and
c) a second thermocouple element printed on the substrate, wherein the second thermocouple element is a carbon ink,
wherein at least a portion of the second thermocouple element is in electrical contact with the first thermocouple element,
and wherein the first and second printed thermocouple elements together produce a thermoelectric effect.

2. The thermocouple according to claim 1, wherein the substrate is a flexible or a non-flexible non-conductive substrate selected from the group consisting of polyethylene terephthalate (PET), treated polyethylene terephthalate, polycarbonate, polyimide, paper, polyurethane, rubber, textiles, polyester, polyolefin and mixtures thereof.

3. The thermocouple according to claim 1 or 2, wherein the substrate is a metal substrate having an insulation coating covering the surface of the metal substrate, wherein the thermocouple is applied onto.

4. The thermocouple according to claim 3, wherein the insulation coating is selected from the group consisting of an epoxy resin, a (meth)acrylate resin, a silicone resin, a polyester resin, a polyurethane resin, a polyvinyl chloride and mixtures thereof, preferably the insulation coating is a (meth)acrylate resin.

5. The thermocouple according to any of claims 1 to 4, wherein the silver ink comprising silver particles, a thermoplastic resin and a solvent

6. The thermocouple according to any of claims 1 to 5, wherein the carbon ink comprising a mixture of carbon-based particles selected from the group consisting of carbon black, graphite, carbon nanotubes, carbon nanoparticles and mixtures thereof; a thermoplastic resin; and a solvent.

7. The thermocouple according to any of claims 1 to 6, wherein the first and second thermocouple elements are printed onto a substrate using screen printing, rotogravure printing, or flexographic printing.

8. The thermocouple according to any of claims 1 to 7, wherein the first thermocouple element is printed first onto a substrate and the second thermocouple element is printed second onto a substrate, or the second thermocouple element is printed first onto a substrate and the first thermocouple element is printed second onto a substrate, preferably the first thermocouple element is printed first onto a substrate and the second thermocouple element is printed second onto a substrate.

9. The thermocouple according to any of claims 1 to 8, wherein the first and second printed thermocouple elements may have a same or different thickness of from 0.1 to 200µm, preferably from 0.5 to 100µm, and more preferably from 1 to 50µm.

10. The thermocouple according to any of claims 1 to 9, wherein the first and second printed thermocouple elements may have a same or different width of from 0.15 to 10mm, preferably from 0.2 to 5mm, and more preferably from 0.5 to 2.5mm.

11. The Thermocouple according any of claims 1 to 10, wherein the thermocouple further comprises electrical connectors electrically coupled to the first and second thermocouple elements.

12. The thermocouple according to any of claims 1 to 11, wherein the thermocouple further comprises an overcoat layer covering partially or full the first and second printed thermocouple elements.

13. The thermocouple according to claim 12, wherein the overcoat layer is selected from the group consisting of an epoxy resin, a (meth)acrylate resin, a silicone resin, a polyester resin, a polyurethane resin, a polyvinyl chloride and mixtures thereof, preferably the overcoat layer is a (meth)acrylate resin.

14. A thermopile, comprising two or more thermocouples according to any of claims 1 to 13, arrayed in close proximity with each other.

15. Use of the thermocouple according to any of claims 1 to 13 or the thermopile according to claim 14 as a temperature sensor.
